Europäisches Patentamt

European Patent Office

Office européen des brevets

(11) Publication number: **0 137 660**
**A2**

(12) # EUROPEAN PATENT APPLICATION

(21) Application number: **84305615.1**

(22) Date of filing: **17.08.84**

(51) Int. Cl.⁴: **H 02 H 7/20**

(30) Priority: **27.09.83 US 536916**

(43) Date of publication of application:
**17.04.85 Bulletin 85/16**

(84) Designated Contracting States:
**AT BE CH DE FR GB IT LI LU NL SE**

(71) Applicant: **MECHATRON SYSTEMS, INC.**
**3350 Scott Boulevard Suite 48**
**Santa Clara California 95051(US)**

(72) Inventor: **Van, Tri S.**
**5007 Anaheim Loop**
**Union City California 94587(US)**

(74) Representative: **Milhench, Howard Leslie et al,**
**R.G.C. Jenkins & Co. 12-15, Fetter Lane**
**London EC4A 1PL(GB)**

(54) **Method and apparatus for masing noise present in an alternating electrical signal.**

(57) A noise masking circuit for eliminating evidence of noise present in an incoming alternating electrical control signal, such as a shaft encoder or tachometer signal in a servo control circuit, is disclosed. A timer is started in response to a negative-going excursion in the incoming alternating electrical control signal. A first logic state output (low state) is produced by the timer in response to the negative-going excursion during a preselected period of time irrespective of the appearance of positive-going excursions which appear in the control signal. The timer is stopped after the preselected time period following the appearance of the negative-going excursion. Subsequently, that is, after the lapse the preselected time period following the initial appearance of the negative-going excursion, a second logic state output (high state) is produced by the timer in response to a positive-going excursion. Preferably, the timing means is restarted in response to the positive-going excursion. A second logic state output (high state) is produced by the timer in response to the positive-going excursion during a second preselected period of time irrespective of the appearance of negative-going excursions which appear in the control signal during the second preselected time period. The timer is stopped after the second preselected time period following the appearance of the positive-going excursion. Subsequently, that is, after the second preselected time period, a first logic state output (low state) is produced by the timer in response to a negative-going excursion. Other features are also disclosed.

Croydon Printing Company Ltd.

./...

FIG._2.

9949-7/TTTTT2

METHOD AND APPARATUS FOR MASKING NOISE PRESENT
IN AN ALTERNATING ELECTRICAL SIGNAL

BACKGROUND OF THE INVENTION

This invention relates to electrical noise detection circuits and, more particularly, to circuits responsive to an incoming alternating electrical signal permeated by noise for producing an outgoing electrical signal in which the noise is suppressed.  Specifically, the invention is directed to a method and apparatus for masking noise present in an incoming alternating electrical control signal for producing an outgoing electrical control signal in which no evidence of the noise appears, especially in inherently noisy environments such as encountered in the use of servomotors in conjunction with the operation of printers, for example, daisy wheel printers, disc drives, and other equipment used in information processing.

In order to facilitate an understanding of the invention, the invention will be described by way of example in connection with printers, namely, daisy wheel printers.  The exemplary use of the invention in connection with a daisy wheel printer, however, is by way of illustration only and is not to be interpreted as a limitation of the principles of the invention to daisy wheel printers or to printers generally.  As will become clear, the principles which underlie the invention apply generally to control circuits responsive to an incoming alternating electrical control signal in which noise is present.

In a daisy wheel printer, a petal shaped print wheel is rotatably mounted to a carriage.  The carriage is reciprocally mounted with respect to a paper feeder so that the reciprocal movement of the carriage is orthogonal with respect to the direction of paper feed, for example, the paper is fed vertically and the carriage is moved horizontally. Rotation of the print wheel, reciprocation of the carriage, and movement of the paper by means of the paper feeder, preconditions the daisy wheel printer for enabling a character to be printed. Printing requires that the paper be indexed to a line position, the carriage be moved to a character position, and the print wheel be rotated to a selected character, whereupon a hammer means is energized for striking the wheel causing the wheel to be impacted on a ribbon interposed between the wheel and the paper, thereby imprinting a character on the paper.

The print wheel and the carriage are moved to the appropriate positions by respective servomechanisms. In the case of the print wheel, the servomechanism is under the control of a host which selects the characters to be printed. The order in which the characters are printed is also determined by the host which selects the character positions.

It is desirable that the carriage is moved to the proper character position and the print wheel is rotated to the proper character before the hammer means is energized for printing the character on the paper. A long extant problem to which the present invention is addressed is that if the print wheel and/or carriage are not properly positioned by the time that the hammer means is energized, the quality of the printing suffers. That is, if there is a disparity between the position of the print wheel and/or carriage specified by the host and the actual position of the print wheel and/or carriage, imprecise positioning results which causes poor registration of the character with respect to a line on the paper, only a portion of the character being printed, and other unacceptable deviant print characteristics. Furthermore, and perhaps an even more onerous problem is that imprecise positioning of the print wheel and/or carriage can result in damage to or breakage of the print wheel. If the print wheel is rotated to an imprecise position evidenced by the petal shaped cantilevered character imprinting element being offset, that is, slightly out of registration with, the hammer means, impact of the hammer means against the character imprinting element can damage or break the element, thereby necessitating replacement of the print wheel.

In view of the criticality which attaches to properly positioning the print wheel and carriage in order to assure print quality and avoid printer downtime, the respective servomechanisms which position the print wheel and carriage include respective servomotors and closed loop servo control circuits responsive to a command signal from the host for controllably moving the print wheel and carriage to one of various positions with negative feedback for maintaining the position until another command signal is provided. Position feedback is generally provided by respective shaft encoder signals or can be derived from respective tachometer signals, and under optimum conditions the shaft encoders or tachometers must produce signals having sufficient signal-to-noise so that proper positioning can be achieved. However, spurious noise generated by noise sources such as alternating current power lines, fluorescent light fixtures, other information processing equipment, etc., in the vicinity of the daisy wheel printer decreases the signal-to-noise ratio of the shaft encoder or tachometer signals. The noise problem is exacerbated by the fact that the brushes of the servomotors themselves generate electrical noise and the daisy wheel printer has other noise sources such as static electrical charges from the paper feeder. Consequently, noise is present which can adversely affect the signal-to-noise ratio of the signals produced by the shaft encoders or tachometers. As a result, the precision with which the print wheel and carriage are positioned can be substantially impaired.

4

In the past, the incoming alternating electrical control signals from the shaft encoders or tachometers have been filtered by analog noise filters in the form of resistor-capacitor filters. The time delays associated with resistor-capacitor filters adversely affect the response of the servo control circuits. Furthermore, the bandwidth of such resistor-capacitor filters is limited. Typically, only low-frequency noise, such as 60 Hz noise, is filtered. If high-frequency noise is filtered, the high-frequency content of the signals produced by the shaft encoders or tachometers is also eliminated. This results in rounding the leading and trailing edges in the case where the signals from the shaft encoders or tachometers are rectangular pulses. Unfortunately, sharp leading and trailing edges are needed in order to assure proper operation of digital circuitry. Furthermore, adjustability of the resistor-capacitor filters requires potentiometers or variable capacitors which are expensive.

The invention provides cancellation of the effects of noise present in an incoming alternating electrical control signal without the limitations of a resistor-capacitor filter. The method and apparatus in accordance with the invention can effectively reduce the impact of noise present in the incoming alternating electrical control signals from the shaft encoders or tachometers included in the servo control circuits for the print wheel and carriage of a daisy wheel printer in order to increase the precision with which the print wheel and carriage are positioned, thereby assuring print quality and avoiding damage to or breakage of the wheel.

SUMMARY OF THE INVENTION

The invention provides a method and apparatus for masking noise which appears in an incoming alternating electrical control signal, such as the signal from a shaft encoder or tachometer included in a servo control circuit of a positioning servomechanism, for example, the servomechanisms included in a daisy wheel printer for positioning a print wheel and carriage. The method and apparatus in accordance with the invention for masking noise present in an alternating electrical control signal are characterized in that the evidence of noise present in the incoming alternating electrical control signal is eliminated without substantially reducing the frequency content of the signal, thereby preserving the waveshape of the signal that would appear if noise were not present. Consequently, the method and apparatus in accordance with the invention are particularly useful where the incoming alternating electrical control signal is a squarewave pulse train for controlling the operation of digital circuitry.

In accordance with the method aspect of the invention, a method for masking noise present in an alternating electrical signal is provided, comprising the steps of: starting a timing means in response to an amplitude change in the electrical signal having a first given character for causing the timing means to time a preselected period of time, a first logic state output being produced by the timing means in response to the amplitude change in the electrical signal having the first given character during the preselected period of time irrespective of the appearance of amplitude changes in the electrical signal having a second given character; and stopping the timing means after the preselected period of time following the appearance of the amplitude change in the electrical signal having the first given character, a second logic state output being produced by the timing means in response to an amplitude change in the electrical signal having the second given character occurring after the lapse of the preselected period of time following the appearance of the amplitude change in the electrical signal having the first given character. Preferably, the method for masking noise present in the alternating electrical signal further comprises the steps of: restarting the timing means in response to the amplitude change in the electrical signal having the second given character occurring after the preselected period of time following the appearance of the amplitude change in the electrical signal having the first given character elapses for causing the timing means to time a second preselected period of time, the second logic state output being produced by the timing means in response to the amplitude change in the electrical signal having the second given character during the second preselected period of time irrespective of the appearance of amplitude changes in the electrical signal having the first given character; and stopping the timing means after the second preselected period of time following the appearance of the amplitude change in the electrical signal having the second given character, a first logic state output being produced by the timing means in response to an amplitude change in the electrical signal having the first given character occurring after the lapse of the second preselected period of time following the appearance of the amplitude change in the electrical signal having the second given character.

In accordance with the apparatus aspect of the invention, one embodiment of apparatus for masking noise present in an alternating electrical signal comprises: a triggerable timing means responsive to amplitude changes in the electrical signal having a given character for producing a first logic state output for a preselected period of time, a second logic state output otherwise being produced by the triggerable timing means; an inverting means for producing an inverted electrical signal; a delay circuit means for producing a delayed inverted electrical signal; a logic circuit means for producing a first logic state output, when the output from the triggerable timing means and the delayed inverted electrical signal assume the second logic state, and a second logic state output, when at least one of the output from the triggerable timing means and the delayed inverted electrical signal assumes the first logic state; thereby masking noise having amplitude changes of the given character within the output from the logic circuit means. Preferably, the apparatus for masking noise present in the alternating electrical signal further comprises: a second triggerable timing means responsive to amplitude changes in the electrical signal having a second given character for producing a first logic state output for a second preselected period of time, a second logic state output otherwise being produced by the second triggerable timing means; a second delay circuit means for producing a delayed electrical signal; a second logic circuit means for producing a first logic state output, when the output from the second triggerable timing means and the delayed electrical signal assume the second logic state, and a second logic state output, when at least one of the output from the second triggerable timing means and the delayed electrical signal assumes the first logic state; a second inverting means for producing an inverted output from the second logic circuit means; a third delay circuit means for producing a delayed output from the second logic circuit means; a third logic circuit means for producing a first logic state output, when the output from the second inverting means and the delayed output from the second logic circuit means assume the second logic state, and a second logic state output, when at least one of the output from the second inverting means and the delayed output from the second logic circuit means assumes the first logic state; a third inverting means for producing an inverted output from the logic circuit means; and a fourth logic circuit means for producing a first logic state output, when the output from the third inverting means transposes to the second logic state, and a second logic state output, when the output from the third logic circuit means transposes to the first logic state; thereby masking noise having amplitude changes of the given character and noise having amplitude changes of the second given character within the output from the fourth logic circuit means.

The method and apparatus in accordance with the invention effectively eliminate the evidence of noise present in an incoming alternating electrical control signal. Consequently, the outgoing electrical control signal appears free from noise.

BRIEF DESCRIPTION OF THE DRAWINGS

The above and other features of the invention and the concomitant advantages will be better understood and appreciated by those skilled in the art in view of the description of the preferred embodiments given below in conjunction with the accompanying drawings. In the drawings:

Figure 1 is a block diagram of an embodiment in accordance with the invention for masking noise present in an alternating electrical signal;

Figure 2 is a schematic circuit diagram for a preferred implementation of the embodiment shown in Figure 1; and

Figure 3 illustrates electrical signals which appear at various nodes of the circuit shown in Figure 2.

DESCRIPTION OF THE PREFERRED EMBODIMENTS

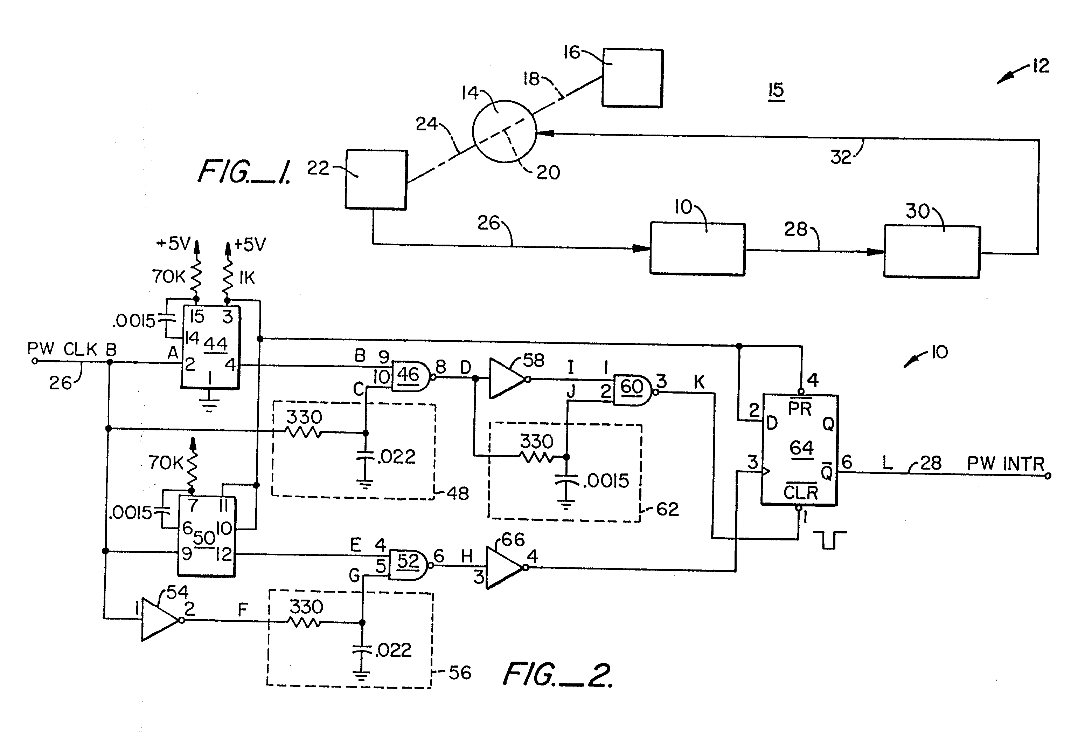

In accordance with the invention, a method and apparatus are provided for masking noise present in an alternating electrical signal. By way of example, an embodiment of the noise masking circuit in accordance with the invention, generally indicated by the numeral 10 in Figure 1, is incorporated into a servo control circuit 12 for a servomotor 14 included in an automated positioning system 15. The servomotor 14 in turn, again by way of example, moves a positionable element 16 in the form of a printing means, such as a print wheel or carriage of a daisy wheel printer, via a mechanical link 18 connected to the drive shaft 20 of the servomotor.

Movement of the positionable element 16 can be detected by any known technique including the use of a shaft encoder or, alternatively, a tachometer. Preferably, as shown in Figure 1, a shaft encoder 22 included in the servo control circuit 12 is connected via a mechanical link 24 to the drive shaft 20 of the servomotor 14. The shaft encoder 22 encodes the angular position of the drive shaft 20, which is correlated to the actual position of the positionable element 16. Movement of the positionable element 16 is evidenced by an alternating electrical control output signal produced by the shaft encoder 22.

The circuit of the shaft encoder 22 preferably includes wave shaping circuitry for filtering the output signal produced by the shaft encoder and for converting the shaft encoder output signal to a squarewave form, that is, a pulse train comprising pulses having either a first logic state (low state) or a second logic state (high state). The filter can comprise a resistor-capacitor filter having a time constant which is dependent upon the particular use to which the servo control circuit 12 shown in Figure 1 is applied. In the case where the positionable element 16 is a printing means, for example, the time constant for the filter can be on the order of 70 microseconds, for example.

The output of the shaft encoder 22 is connected by a lead 26 to the input of the noise masking circuit 10. The output of the noise masking circuit 10 is connected by a lead 28 to a servomotor drive circuit 30 which produces a drive signal fed to the servomotor 14 over leads 32.

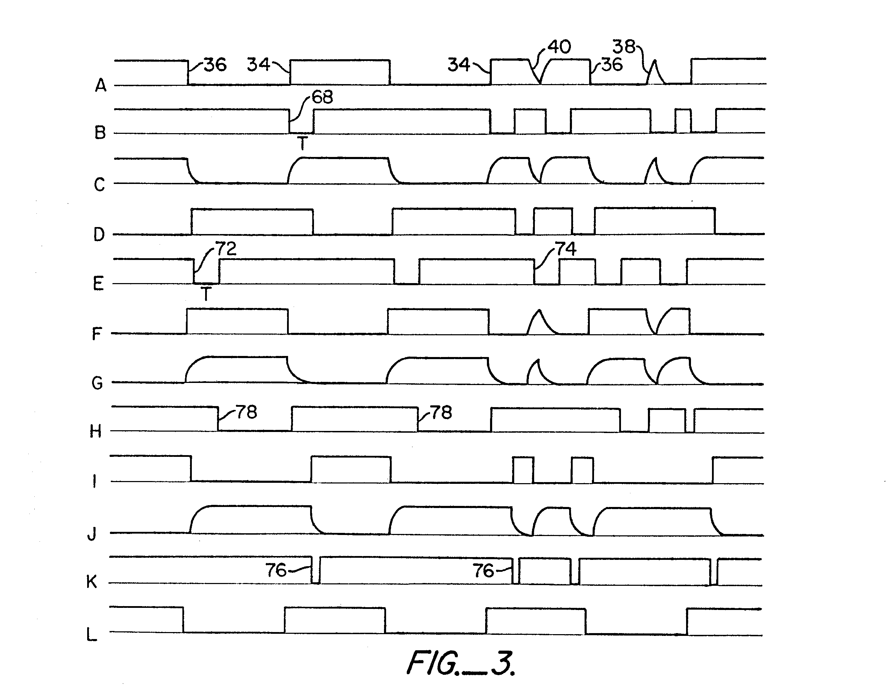

As mentioned earlier, spurious noise can appear in the output signal from the shaft encoder 22. The output signal from the shaft encoder 22 is typically or can be converted to a squarewave pulse train. The pulse train from the shaft encoder 22, which appears on the lead 26, can have the form shown in Figure 3A, for example. As shown in Figure 3A, the pulse train is characterized by being an alternating electrical signal comprised of squarewave pulses having leading edges 34 as represented by amplitude changes of a first given character, for example, positive-going, or rising, amplitude changes. Furthermore, the pulses have trailing edges 36 as represented by amplitude changes of a second given character, that is, negative-going, or falling, amplitude changes.

As shown in Figure 3A, noise is present in the pulse train from the shaft encoder 22, specifically, noise having an amplitude change of the first given character, that is, a positive-going amplitude change, as indicated at 38. The noise 38 is similar to a leading edge 34 of the pulse train from the shaft encoder 22. Also, noise can be present as indicated at 40 as shown in Figure 3A having an amplitude change of the second given character, that is, a negative-going amplitude change, which is similar to a trailing edge 36 of the pulse train from the shaft encoder 22. The noise masking circuit 10 shown in Figure 1 is responsive to the incoming alternating electrical control signal in the form of the pulse train from the shaft encoder 22 for masking the noise 38 and noise 40 shown in Figure 3A in order to provide an outgoing alternating electrical control signal as shown in Figure 3L in which there is no evidence of the noise.

Referring again to Figure 1, the noise masking circuit 10 is responsive to an incoming alternating electrical control signal on the lead 26 from the shaft encoder 22 for detecting noise present in the signal and producing an outgoing alternating electrical control signal on the lead 28, in which evidence of the noise does not appear. One embodiment of the noise masking circuit 10 is shown in Figure 2.

The noise-laden alternating electrical control signal shown in Figure 3A appears on the lead 26 shown in Figure 2, which is also designated as node A corresponding to the circuit location where the signal shown in Figure 3A appears. The lead 26 is connected to a trigger input (pin 2) of a one shot 44 (preferably a type 74LS221 integrated circuit) such that the one shot is triggered in response to changes in amplitude of the incoming alternating electrical control signal having the first given character, namely, a positive-going amplitude change. In response to such positive-going amplitude changes, the one shot 44 is triggered so that the one shot produces the first logic state (low state) at an output (pin 4) of the one shot for a first preselected period of time. The first preselected time period is determined by the resistor-capacitor circuit connected to time constant inputs (pins 14 and 15) of the one shot 44. The time constant, for example, can be 70 microseconds. The output of the one shot 44 is connected to one input (pin 9) of a NAND gate 46 (preferably a type 7400 integrated circuit). The other input (pin 10) of the NAND gate 46 is connected through a delay circuit 48 to the lead 26 so that a delayed representation of the incoming alternating electrical control signal forms the other input to the NAND gate. The circuit 44, 46, 48 masks noise of the first given character, namely, positive-going noise, such as the noise 38 shown in Figure 3A.

As shown in Figure 2, the lead 26 is also connected to a trigger input (pin 9) of a one shot 50 (preferably a type 74LS221 integrated circuit) such that the one shot is triggered in response to changes in amplitude of the incoming alternating electrical control signal having the second given character, namely, a negative-going amplitude change. In response to such negative-going amplitude changes, the one shot 50 is triggered so that the one shot produces the first logic state (low state) at an output (pin 12) of the one shot for a second preselected period of time. The second preselected time period is determined by the resistor-capacitor circuit connected to time constant inputs (pins 6 and 7) of the one shot 50. Preferably, the time constant is 70 microseconds. The output of the one shot 50 is connected to one input (pin 4) of a NAND gate 52 (preferably a type 7400 integrated circuit). The other input (pin 5) of the NAND gate 52 is connected through an inverter 54 and a delay circuit 56 to the lead 26 so that an inverted and delayed representation of the incoming alternating electrical control signal forms the other input to the NAND gate. The circuit 50, 52, 54, 56 masks noise of the second given character, namely, negative-going noise, such as the noise 40 shown in Figure 3A.

In order that an outgoing alternating electrical control signal is produced in which both the noise 38 and noise 40 shown in Figure 3A are masked, the output (pin 8) of the NAND gate 46 is connected to the input of an inverter 58. The output of the inverter 58 is in turn connected to one input (pin 1) of a NAND gate 60, the other input (pin 2) of the NAND gate being connected through a delay circuit 62 to the output of the NAND gate 46 so that a delayed representation of the output signal from the NAND gate 46 forms the other input to the NAND gate 60. The output (pin 3) of the NAND gate 60 is connected to a reset or clear input (pin 1) of a D flip-flop 64 (preferably a type 7474 integrated circuit).

Additionally, in order that an outgoing alternating electrical control signal in which both the noise 40, as well as the noise 38, shown in Figure 3A are masked, the output (pin 6) of the NAND gate 52 is connected to the input (pin 3) of an inverter 66. The output (pin 4) of the inverter 66 is connected to a clock input (pin 3) of the D flip-flop 64.

In order that both positive-going and negative-going noise, such as the noise 38 and 40, respectively, shown in Figure 3A, is masked, the output of the NAND gate 60 is connected to the reset or clear input of the D flip-flop 64 as earlier described. Also, the output of the inverter 66 is connected to the clock input of the D flip-flop 64 as already described. Additionally, a positive voltage is applied to the D input (pin 2) of the D flip-flop 64, and a positive voltage is also applied to the preset input (pin 4) of the D flip-flop. The D flip-flop 64 is preset for producing the second logic state (high state) output signal from a $\bar{Q}$ output (pin 6) of the D flip-flop.

The D flip-flop 64 is clocked by positive-going excursions of the output signal from the inverter 66. Each time that the D flip-flop 64 is clocked, the output signal from the $\bar{Q}$ output of the D flip-flop transposes to the second logic state (low state). The D flip-flop 64 is reset or cleared by negative-going excursions of the output signal from the NAND gate 60. Each time that the D flip-flop 64 is reset, the output signal from the $\bar{Q}$ output of the D flip-flop transposes back to the second logic state (high state). Lastly, the $\bar{Q}$ output of the D flip-flop 64 is connected to the lead 28. The circuit 58, 60, 62, 64, 66 combines the output signal from the circuit 44, 46, 48 and the output signal from the circuit 50, 52, 54, 56 so that noise having an amplitude change of the first given character, namely, positive-going noise, such as the noise 38 shown in Figure 3A, and noise having an amplitude change of the second given character, namely, negative-going noise, such as the noise 40 shown in Figure 3A, do not appear in the outgoing alternating electrical control signal on the lead 28.

The circuit shown in Figure 2 is preferably implemented in TTL circuitry. However, different logic circuitry can be used.

The detailed operation of the noise masking circuit 10 shown in Figure 2 can be facilitated by reference jointly to Figures 2 and 3. The incoming alternating electrical control signal shown in Figure 3A which appears on the lead 26 is input to the one shot 44. The one shot 44 is responsive to amplitude changes of the first given character, namely, positive-going amplitude changes, such as the leading edges 34 and the noise 38 shown in Figure 3A. The output signal produced by the one shot 44 transposes from the second logic state (high state) to the first logic state (low state) in response to the leading edges 34 of the incoming alternating electrical control signal, as well as in response to the noise 38.

The output signal from the one shot 44 at node B shown in Figure 2 is shown in Figure 3B. As shown in Figure 3B, each time a transposition from the first logic state (low state) to the second logic state (high state) occurs at the trigger input of the one shot 44, the output signal produced by the one shot transposes from the second logic state (high state) to the first logic state (low state) for a first preselected period of time. The transposition of the output signal produced by the one shot 44 as pointed out can be both in response to a leading edge 34 of the incoming alternating electrical control signal, as indicated by the transposition 68 shown in Figure 3B, as well as in response to the noise 38, as indicated in Figure 3B at 70. The delay circuit 48 produces a delayed representation of the incoming alternating electrical control signal at node C shown in Figure 2, which corresponds to the delayed incoming alternating electrical control signal shown in Figure 3C.

The output signal from the one shot 44 and the delayed representation of the incoming alternating electrical control signal are input to the NAND gate 46. The NAND gate 46 produces the second logic state (high state) when either or both of the output signal from the one shot 44 and the delayed representation of the incoming alternating electrical control signal are at the first logic state (low state). The output signal produced by the NAND gate 46 appears at node D shown in Figure 2, which corresponds to the signal shown in Figure 3D. As a consequence of the operation of the one shot 44 in response to the positive-going noise 38, which produces the first logic state (low state) 70 shown in Figure 3B, and the logical combination of the output signal from the one shot with the delayed representation of the incoming alternating electrical control signal by means of the NAND gate 46, there is no evidence of the noise 38 in the output signal produced by the NAND gate, as indicated in Figure 3D.

The incoming alternating electrical control signal shown in Figure 3A which appears on the lead 26 shown in Figure 2 is also input to the one shot 50. The one shot 50 is responsive to amplitude changes of the second given character, namely negative-going amplitude changes, such as the trailing edges 36 and the noise 40 shown in Figure 3A. The output signal produced by the one shot 50 transposes from the second logic state (high state) to the first logic state (low state) in response to the trailing edges 36 of the incoming alternating electrical control signal, as well as in response to the noise 40. The output signal produced by the one shot 50 at node E shown in Figure ? is shown in Figure 3E. As shown in Figure 3E, each time a transposition from the second logic state (high state) to the first logic state (low state) occurs in the incoming alternating electrical control signal, the output signal produced by the one shot 50 transposes from the second logic state (high state) to the first logic state (low state) for a second preselected period of time. The transposition of the output signal produced by the one shot 50 as pointed out can be both in response to a leading edge 34 of the incoming alternating electrical control signal, as indicated by the transposition 72 shown in Figure 3E, as well as in response to the noise 40, as indicated in Figure 3E at 74.

Furthermore, the incoming alternating electrical control signal is inverted by the inverter 54 which produces an inverted representation of the incoming alternating electrical control signal shown in Figure 3F at node F shown in Figure 2. The inverted representation of the incoming alternating electrical control signal from the inverter 54 is then delayed by the delay circuit 56 shown in Figure 2 such that an inverted and delayed representation of the incoming alternating electrical control signal as shown in Figure 3G appears at node G shown in Figure 2.

The output signal from the one shot 50 and the inverted and delayed representation of the incoming alternating electrical control signal from the delay circuit 56, shown in Figures 3E and 3G, respectively, are logically combined by means of the NAND gate 52. The output signal produced by the NAND gate 52 transposes to the second logic state (high state) when either or both of the output signal from the one shot 50 and the inverted and delayed representation of the incoming alternating electrical control signal are at the first logic state (low state). As can be seen from Figure 3H, evidence of the noise 40 is not present in the output signal from the NAND gate 52 as a consequence of the operation of the one shot 50 in response to the noise 40, which produces the first logic state (low state) 74, and the logical combination of the output signal from the one shot with the inverted and delayed representation of the incoming alternating electrical control signal by the NAND gate.

In order that a combined signal, in which both the noise 38 and noise 40 are eliminated, is produced, the output signal from the NAND gate 46 is inverted by the inverter 58 and also delayed by the delay circuit 62. The inverted output signal from the NAND gate 46 shown in Figure 3I appears at node I shown in Figure 2, while the delayed representation of the output signal from the NAND gate shown in Figure 3J appears at node J shown in Figure 2. The inverted output signal from the NAND gate 46 and the delayed output signal from the NAND gate, shown in Figures 3I and 3J, respectively, are logically combined by means of the NAND gate 60. The output signal produced by the NAND gate 60 is the second logic state (high state) when either or both of the inverted output signal from the NAND gate 46 and the delayed representation of the output signal from the NAND gate 46 are at the first logic state (low state). The output signal from the NAND gate 60 appears at node K shown in Figure 2 and is shown in Figure 3K.

The output signal from the NAND gate 60 shown in Figure 3K resets or clears the D flip-flop 64 when the falling edges 76 shown in Figure 3K occur. Furthermore, the output signal from the inverter 66 clocks the D flip-flop 64 when the falling edges 78 shown in Figure 3H in the output signal from the NAND gate 52 occur.

Each time that the D flip-flop 64 is reset by the output signal from the NAND gate 60, the $\bar{Q}$ output signal from the D flip-flop transposes to the second logic state (high state). Conversely, each time that the output signal from the inverter 66 transposes from the first logic state (low state) to the second logic state (high state), the D flip-flop 64 is clocked so

that the $\bar{Q}$ output signal from the D flip-flop transposes to the first logic state (low state). The $\bar{Q}$ output signal from the D flip-flop 64 appears at node L shown in Figure 2 and is shown in Figure 3L and comprises the logical combination of the output signal from the circuit 44, 46, 48 and the output signal from the circuit 50, 52, 54, 56 for masking the noise 38 and noise 40 in the incoming alternating electrical control signal shown in Figure 3A. The $\bar{Q}$ output signal from the D flip-flop 64 provides an outgoing alternating electrical control signal in which evidence of the noise 38 and noise 40 is eliminated at the node L shown in Figure 2, which corresponds to the lead 28.

In summary, when what appears to be a leading edge 34 of the incoming alternating electrical control signal is detected, a timing means in the form of the one shot 44 is started and times a predetermined period, preferably 70 microseconds. If the transposition to the second logic state (high state) signaled by the apparent leading edge disappears during the 70-microsecond period, the positive-going electrical signal is considered to be noise. If the second logic state (high state) persists for the 70-microsecond period, the positive-going electrical signal is considered to be a valid pulse leading edge, and, thereafter, the appearance of additional positive-going amplitude changes is ignored. This condition continues until what appears to be a trailing edge 36 of the incoming alternating electrical control signal is sensed.

Similar to the case of detection of a valid leading edge 34 of a pulse, when what appears to be a trailing edge 36 of the incoming alternating electrical control signal is detected, a timing means in the form of the one shot 50 is started and times a predetermined period, preferably 70 microseconds. If the transposition to the first logic state (low state) signaled by the apparent trailing edge disappears during the 70- microsecond period, the negative-going electrical signal is considered to be noise. If the first logic state (low state) persists for the 70-microsecond period, the negative-going electrical signal is considered to be a valid pulse trailing edge, and, thereafter, the appearance of additional negative-going amplitude changes is ignored until such time as a valid leading edge 34 of a pulse is again sensed.

Preferably, the preselected time constants for the one shot 44 and the one shot 50 are equal and are 70 microseconds, but the first and second preselected times do not need to be equal. That is, the respective preselected time constants for the one shot 44 and one shot 50 can be different. Furthermore, the first and second preselected times can be other than 70 microseconds. In the case where the noise masking circuit 10 is incorporated into the servo control circuit 12 shown in Figure 1, the time is preferably keyed to the slew rate for the servomotor 14. The slew rate for the servomotor 14, for example, can be 300 microseconds. The choice of 70 microseconds is based on the selection of approximately one-fourth of the slew period so that valid leading and trailing edges in the incoming alternating electrical control signal are not missed.

Although one embodiment of the noise masking circuit 10 is shown in Figure 2, the apparatus for masking noise present in an alternating electrical control signal in accordance with the invention can be implemented by other means, namely, a microprocessor circuit having a set of programmed instructions stored in a read only memory included in the microprocessor. In the case that a microprocessor circuit is used, noise masking can proceed by providing the incoming alternating electrical control signal from the shaft encoder 22 to an input port of the microprocessor circuit which has a priority interrupt capability. With priority interrupt enabled, that is, the priority interrupt bit set, the microprocessor circuit can continuously sample the incoming alternating electrical control signal for transposition to the second logic state (high state). Once the transposition occurs and has been detected, the microprocessor circuit can continue to sample the incoming alternating electrical control signal for a first preselected time period, such as 70 microseconds as in the case of the circuit shown in Figure 2. If the incoming alternating electrical control signal remains at the second logic state (high state) throughout the first preselected time period, the priority interrupt is disabled, the transposition is considered valid, and any further positive-going transpositions are ignored. Thereafter, when the incoming alternating electrical control signal transposes to the first logic state (low state), the microprocessor circuit can sample the incoming alternating electrical control signal for a second preselected time period, such as 70 microseconds, and, if the first logic state (low state) continues throughout the second preselected time period, the priority interrupt is enabled again. Whenever the priority interrupt is enabled, the microprocessor circuit is conditioned to respond to positive-going transpositions in the incoming alternating electrical control signal. Those transpositions occurring for less than 70 microseconds are considered to be noise and are simply ignored.

In actual tests conducted, the noise masking circuit in accordance with the invention has enabled error free operation of extremely noisy servomechanisms in daisy wheel printers. Consequently, the method and apparatus in accordance with the invention solve the problem of noise in the shaft encoder or tachometer signals causing erroneous interpretation of the operation of the print wheel and carriage. As a result, the quality of printing is improved and damage to or breakage of the print wheel is avoided.

While various embodiments of a noise masking circuit have been described in order to make the invention understandable to those skilled in the art, it will be appreciated that modifications not mentioned will become apparent to those skilled in the art. It is to be clearly understood that the above description is by way of example and illustration only and is not to be taken by way of limitation. Accordingly, the spirit and scope of this invention are ascertainable only by reference to the appended claims.

CLAIMS:

1. A method for masking noise present in an alternating electrical signal, comprising the steps of:

starting a timing means in response to an amplitude change in the electrical signal having a first given character for causing the timing means to time a preselected period of time, a first logic state output being produced by the timing means in response to the amplitude change in the electrical signal having the first given character during the preselected period of time irrespective of the appearance of amplitude changes in the electrical signal having a second given character; and

stopping the timing means after the preselected period of time following the appearance of the amplitude change in the electrical signal having the first given character, a second logic state output being produced by the timing means in response to an amplitude change in the electrical signal having the second given character occurring after the lapse of the preselected period of time following the appearance of the amplitude change in the electrical signal having the first given character.

2. The method of Claim 1, further comprising the steps of:

restarting the timing means in response to the amplitude change in the electrical signal having the second given character occurring after the preselected period of time following the appearance of the amplitude change in the electrical signal having the first given character elapses for causing the timing means to time a second preselected period of time, the second logic state output being produced by the timing means in response to the amplitude change in the electrical signal having the second given character during the preselected period of time irrespective of the appearance of amplitude changes in the electrical signal having the first given character; and

stopping the timing means after the second preselected period of time following the appearance of the amplitude change in the electrical signal having the second given character, a first logic state output being produced by the timing means in response to an amplitude change in the electrical signal having the first given character occurring after the lapse of the second preselected period of. time following the appearance of the amplitude change in the electrical signal having the second given character.

3. The method of Claim 2 wherein the preselected period of time and the second preselected period of time are equal.

4. A method for masking noise present in an alternating electrical signal, comprising the steps of:

inputting the electrical signal to a triggerable timing means;

triggering the triggerable timing means in response to amplitude changes in the electrical signal having a given character for causing the triggerable timing means to produce a first logic state output for a preselected period of time, a second logic state output otherwise being produced by the triggerable timing means;

inputting the electrical signal to a delay circuit means for causing the delay circuit means to produce a delayed electrical signal; and

inputting the output from the triggerable timing means and the delayed electrical signal to a logic circuit means for producing a first logic state output, when the output from the triggerable timing means and the delayed electrical signal assume the second logic state, and a second logic state output, when at least one of the output from the triggerable timing means and the delayed electrical signal assumes the first logic state;

whereby noise having amplitude changes of the given character is masked within the output from the logic circuit means.

5. The method of Claim 4, further comprising the steps of:

inputting the electrical signal to a second triggerable timing means;

triggering the second triggerable timing means in response to amplitude changes in the electrical signal having a second given character for causing the second triggerable timing means to produce a first logic state output for a second preselected period of time, a second logic state output otherwise being produced by the second triggerable timing means;

inputting the electrical signal to a first inverting means for causing the first inverting means to produce an inverted electrical signal;

inputting the inverted electrical signal to a second delay circuit means for causing the second delay circuit means to produce a delayed inverted electrical signal;

inputting the output from the second triggerable timing means and the delayed inverted electrical signal to a second logic circuit means for producing a first logic state output, when the output from the second triggerable timing means and the delayed inverted electrical signal assume the second logic state, and a second logic state output, when at least one of the output from the second triggerable timing means and the delayed inverted electrical signal assumes the first logic state;

inputting the output from the logic circuit means to a second inverting means for causing the second inverting means to produce an inverted output from the logic circuit means;

inputting the output from the logic circuit means to a third delay circuit means for causing the third delay circuit means to produce a delayed output from the logic circuit means;

inputting the output from the second inverting means and the delayed output from the logic circuit means to a third logic circuit means for producing a first logic state output, when the output from the second inverting means and the delayed output from the logic circuit means assume the second logic state, and a second logic state output, when at least one of the output from the second inverting means and the delayed output from the logic circuit means assumes the first logic state;

inputting the output from the second logic circuit means to a third inverting means for causing the third inverting means to produce an inverted output from the second logic circuit means; and

inputting the outputs from the third logic circuit means and third inverting means to a fourth logic circuit means for producing a first logic state output, when the output from the third inverting means transposes to the second logic state, and a second logic state output, when the output from the third logic circuit means transposes to the first logic state;

whereby noise having amplitude changes of the given character and noise having amplitude changes of the second given character are masked within the output from the fourth logic circuit means.

6. The method of Claim 5 wherein the preselected period of time and the second preselected period of time are equal.

7.    A method for masking noise present in an alternating electrical signal, comprising the steps of:

inputting the electrical signal to a triggerable timing means;

triggering the triggerable timing means in response to amplitude changes in the electrical signal having a given character for causing the triggerable timing means to produce a first logic state output for a preselected period of time, a second logic state output otherwise being produced by the triggerable timing means;

inputting the electrical signal to an inverting means for causing the inverting means to produce an inverted electrical signal;

inputting the inverted electrical signal to a delay circuit means for causing the delay circuit means to produce a delayed inverted electrical signal;

inputting the output from the triggerable timing means and the delayed inverted electrical signal to a logic circuit means for producing a first logic state output, when the output from the triggerable timing means and the delayed inverted electrical signal assume the second logic state, and a second logic state output, when at least one of the output from the triggerable timing means and the delayed inverted electrical signal assumes the first logic state;

whereby noise having amplitude changes of the given character is masked within the output from the logic circuit means.

8.    The method of Claim 7, further comprising the steps of:

inputting the electrical signal to a second triggerable timing means;

triggering the second triggerable timing means in response to amplitude changes in the electrical signal having a second given character for causing the second triggerable timing means to produce a first logic state output for a second preselected period of time, a second logic state output otherwise being produced by the second triggerable timing means;

inputting the electrical signal to a second delay circuit means for causing the second delay circuit means to produce a delayed electrical signal;

inputting the output from the second triggerable timing means and the delayed electrical signal to a second logic circuit means for producing a first logic state output, when the output from the second triggerable timing means and the delayed electrical signal assume the second logic state, and a second logic state output, when at least one of the output from the second triggerable timing means and the delayed electrical signal assumes the first logic state;

inputting the output from the second logic circuit means to a second inverting means for causing the second inverting means to produce an inverted output from the second logic circuit means;

inputting the output from the second logic circuit means to a third delay circuit means for causing the second delay circuit means to produce a delayed output from the second logic circuit means;

inputting the output from the second inverting means and the delayed output from the second logic circuit means to a third logic circuit means for producing a first logic state output, when the output from the second inverting means and the delayed output from the second logic circuit means assume the second logic state, and a second logic state output, when at least one of the output from the second inverting means and the delayed output from the second logic circuit means assumes the first logic state;

inputting the output from the logic circuit means to a third inverting means for causing the third inverting means to produce an inverted output from the logic circuit means; and

inputting the outputs from the third logic circuit means and the third inverting means to a fourth logic circuit means for producing a first logic state output, when the output from the third inverting means transposes to the second logic state, and a second logic state output, when the output from the third logic circuit means transposes to the first logic state;

whereby noise having amplitude changes of the given character and noise having amplitude changes of the second given character are masked within the output from the fourth logic circuit means.

9.    The method of Claim 8 wherein the preselected period of time and the second preselected period of time are equal.

10.    Apparatus for masking noise present in an alternating electrical signal, comprising:

a timing means started in response to an amplitude change in the electrical signal having a first given character for timing a preselected period of time, a first logic state output being produced by the timing means in response to the amplitude change in the electrical signal having the first given character during the preselected period of time irrespective of the appearance of amplitude changes in the electrical signal having a second given character;

the timing means being stopped after the preselected period of time following the appearance of the amplitude change in the electrical signal having the first given character, a second logic state output being produced by the timing means in response to an amplitude change in the electrical signal having the second given character occurring after the lapse of the preselected period of time following the appearance of the amplitude change in the electrical signal having the first given character.

11. The apparatus of Claim 10 wherein the timing means is restarted in response to the amplitude change in the electrical signal having the second given character occurring after the preselected period of time following the appearance of the amplitude change in the electrical signal having the first given character elapses for timing a second preselected period of time, the second logic state output being produced by the timing means in response to the amplitude change in the electrical signal having the second given character during the second preselected period of time irrespective of the appearance of amplitude changes in the electrical signal having the first given character; the timing means being stopped after the second preselected period of time following the appearance of the amplitude change in the electrical signal having the second given character, a first logic state output being produced by the timing means in response to an amplitude change in the electrical signal having the first given character occurring after the lapse of the second preselected period of time following the appearance of the amplitude change in the electrical signal having the second given character.

12. The apparatus of Claim 11 wherein the preselected period of time and the second preselected period of time are equal.

13. Apparatus for masking noise present in an alternating electrical signal, comprising:
        a triggerable timing means responsive to amplitude changes in the electrical signal having a given character for producing a first logic state output for a preselected period of time, a second logic state output otherwise being produced by the triggerable timing means;

a delay circuit means for producing a delayed electrical signal; and

a logic circuit means for producing a first logic state output, when the output from the triggerable timing means and the delayed electrical signal assume the second logic state, and a second logic state output, when at least one of the output from the triggerable timing means and the delayed electrical signal assumes the first logic state;

thereby masking noise having amplitude changes of the given character within the output from the logic circuit means.

14. The apparatus of Claim 13, further comprising:

a second triggerable timing means responsive to amplitude changes in the electrical signal having a second given character for producing a first logic state output for a second preselected period of time, a second logic state output otherwise being produced by the second triggerable timing means;

a first inverting means for producing an inverted electrical signal;

a second delay circuit means for producing a delayed inverted electrical signal;

a second logic circuit means for producing a first logic state output, when the output from the second triggerable timing means and the delayed inverted electrical signal assume the second logic state, and a second logic state output, when at least one of the output from the second triggerable timing means and the delayed inverted electrical signal assumes the first logic state;

a second inverting means for producing an inverted output from the logic circuit means;

a third delay circuit means for producing a delayed output from the logic circuit means;

a third logic circuit means for producing a first logic state output, when the output from the second inverting means and the delayed output from the logic circuit means assume the second logic state, and a second logic state output, when at least one of the output from the second inverting means and the delayed output from the logic circuit means assumes the first logic state;

a third inverting means for producing an inverted output from the second logic circuit means; and

a fourth logic circuit means for producing a first logic state output, when the output from the third inverting means transposes to the second logic state, and a second logic state output, when the output from the third logic circuit means transposes to the first logic state;

thereby masking noise having amplitude changes of the given character and noise having amplitude changes of the second given character within the output from the fourth logic circuit means.

15. The apparatus of Claim 14 wherein the preselected period of time and the second preselected period of time are equal.

16. Apparatus for masking noise present in an alternating electrical signal, comprising:

a triggerable timing means responsive to amplitude changes in the electrical signal having a given character for producing a first logic state output for a preselected period of time, a second logic state output otherwise being produced by the triggerable timing means;

an inverting means for producing an inverted electrical signal;

a delay circuit means for producing a delayed inverted electrical signal;

a logic circuit means for producing a first logic state output, when the output from the triggerable timing means and the delayed inverted electrical signal assume the second logic state, and a second logic state output, when at least one of the output from the triggerable timing means and the delayed inverted electrical signal assumes the first logic state;

thereby masking noise having amplitude changes of the given character within the output from the logic circuit means.

17.     The apparatus of Claim 16, further comprising:

a second triggerable timing means responsive to amplitude changes in the electrical signal having a second given character for producing a first logic state output for a second preselected period of time, a second logic state output otherwise being produced by the second triggerable timing means;

a second delay circuit means for producing a delayed electrical signal;

a second logic circuit means for producing a first logic state output, when the output from the second triggerable timing means and the delayed electrical signal assume the second logic state, and a second logic state output, when at least one of the output from the second triggerable timing means and the delayed electrical signal assumes the first logic state;

a second inverting means for producing an inverted output from the second logic circuit means;

a third delay circuit means for producing a delayed output from the second logic circuit means;

a third logic circuit means for producing a first logic state output, when the output from the second inverting means and the delayed output from the second logic circuit means assume the second logic state, and a second logic state output, when at least one of the output from the second inverting means and the delayed output from the second logic circuit means assumes the first logic state;

a third inverting means for producing an inverted output from the logic circuit means; and

a fourth logic circuit means for producing a first logic state output, when the output from the third inverting means transposes to the second logic state, and a second logic state output, when the output from the third logic circuit means transposes to the first logic state;

thereby masking noise having amplitude changes of the given character and noise having amplitude changes of the second given character within the output from the fourth logic circuit means.

18. The apparatus of Claim 17 wherein the preselected period of time and the second preselected period of time are equal.

19. A method of noise reduction processing of a signal having alternate first and second states which comprises determining whether or not a transition between one and the other of said states persists for a determined period and in dependence thereupon reconstituting the signal so as to retain or exclude the respective transposition from the reconstituted signal.

20. Apparatus for noise reduction processing of a signal having alternate first and second states comprising means for determining whether or not a transition between one and the other of said states persists for a determined period, and for reconstituting the signal so as to retain or exclude the respective transition from the reconstituted signal.

FIG._1.

FIG._2.

0137660

27-09-84

0137660

FIG._3.